(19) Europäisches Patentamt / European Patent Office / Office européen des brevets

(11) **EP 3 396 730 A1**

(12) **EUROPEAN PATENT APPLICATION**

(43) Date of publication:
**31.10.2018 Bulletin 2018/44**

(51) Int Cl.:
**H01L 51/48** *(2006.01)*

(21) Application number: **17196647.6**

(22) Date of filing: **16.10.2017**

| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br>Designated Validation States:<br>**MA MD** | • **EISENHOFER, Lena**<br>**93059 Regensburg (DE)**<br>• **TAM, Eric**<br>**90419 Nürnberg (DE)**<br>• **EGELHAAF, Hans-Joachim**<br>**90403 Nürnberg (DE)**<br>• **BRABEC, Christoph J.**<br>**90403 Nürnberg (DE)**<br>• **VOIGT, Monika**<br>**90408 Nürnberg (DE)** |
| (30) Priority: **28.04.2017 EP 17168806** | |
| (71) Applicant: **Bayerisches Zentrum für Angewandte Energieforschung e. V.**<br>**97074 Würzburg (DE)** | (74) Representative: **Dr. Gassner & Partner mbB**<br>**Marie-Curie-Str. 1**<br>**91052 Erlangen (DE)** |
| (72) Inventors:<br>• **MAISCH, Philipp**<br>**97659 Fladungen (DE)** | |

(54) **METHOD OF APPLYING UPON A SUBSTRATE A SOLID LAYER FROM A SOLUTION**

(57)     The invention concerns a method of applying upon a substrate a solid layer from a liquid which does not wet the substrate, the method comprising the following steps:

Defining on the surface of the substrate an area to be provided with the solid layer,

Printing by means of an inkjet printer a regular 2-dimensional pattern of discrete droplets within the area, wherein adjacent droplets are arranged at a predetermined distance,

Drying the droplets thereby forming islands of a solid material,

Covering the area containing the islands by a liquid layer of the liquid, and

Drying the liquid layer thereby forming the solid layer.

**Fig. 1**

Step 1: Printing of single drops

Step 2: Drying to form anchoring points

Step 3: Printing of continuous layer

## Description

The invention concerns a method for applying upon a substrate a solid layer from a liquid which does not wet the substrate.

If the surface energy of a surface of substrate is smaller than a surface tension of solution to be printed on the surface due to the poor wetting behavior of the solution the printing or coating qualities are often not satisfying. A common way of improving the wetting behavior of the solution is the use of wetting agents. However, wetting agents usually remain within a layer which remains after drying of the solution. The wetting agents may have an undesirable impact on the properties of the layer.

In order to overcome this problem there is known from Chen et al., Fabrication of Nanoscale Circuits on Inkjet-Printing Patterned Substrates, Adv. Mater. 27 (2015) 3928-3933. DOI:10.1002/adma.201500225, a non-lithography process for the fabrication of nanoscale circuits on inkjet printed patterned substrates. An aqueous solution containing silver nanoparticles was inkjet printed in a well-defined pattern onto a flat substrate being treated with octadecyltrichlorosilane. The pattern consists of small droplets which formed after drying small islands of silver nanoparticles. Afterwards an aqueous solution containing silver nanoparticles was dropped on the patterned substrate and then covered with a flat plate. Then the solution was evaporated. The solid islands served as wetting defects. Liquid bridges were formed between neighboring islands. By the proposed method nanoscale lines made of silver nanoparticles were formed connecting the islands.

A. Colsmann et al., Inverted semi-transparent organic solar cells with spray coated, surfactant fee polymer top-electrodes, Sol. Energy Mater. Sol. Cells. 98 (2012) 118-123 DOI:10.1016/j.solmat.2011.10.016, discloses a method for applying upon a blend of poly(3-hexylthiophene) (P3HT) and phenyl-C61-butylic acid methyl ester (PCBM) (= P3HT: PCBM) surface a poly(3,4-ethylenedioxythiophene) polystyrene sulfonate (= PEDOT:PSS) solid a layer made by solution processing. On the substrate made of P3HT:PCBM there was sprayed by the use of an ultrasonic atomizing nozzle system a PEDOT:PSS solution. On the substrate there were formed small droplets. The droplets were dried and formed a random pattern of solid islands. Afterwards there was again sprayed a PEDOT:PSS solution on the surface. The spraying was done with an increased flow rate. The wet film applied upon the substrate was again dried resulting in a solid a layer made of PEDOT:PSS. - However, the layer is not uniform in thickness. Further, for producing a layer in a predetermined 2-dimensional pattern it is necessary to use masks or the like.

The object underlying the present invention is to avoid the disadvantages in the art. There shall be provided a method of applying upon a substrate a solid layer from a solution, where a surface energy of surface of the substrate is smaller than a surface tension of the solution without using surfactants in the solution. In particular the method shall be performed easily and result in the provision of well-defined 2-dimensional structures.

This object is solved by the features of claim 1. Embodiments of the invention result from the features of the dependent claims.

In accordance with the invention there is proposed a method of applying upon a substrate a solid layer from a liquid which does not wet the substrate, the method comprising the following steps:

Defining on the surface of the substrate an area to be provided with the solid layer,

Printing by means of an inkjet printer a regular 2-dimensional pattern of discrete droplets within the area , wherein adjacent droplets are arranged at a predetermined distance,

Drying the droplets thereby forming islands of a solid material,

Covering the area containing the islands by a liquid layer of the liquid, and

Drying the liquid layer thereby forming the solid layer.

The context of the present invention there is understood under "a liquid which does not wet the substrate" a liquid which does not form a geometrical stable film upon a substrate. The film shows ruptures and/or shrinkages.

With the present invention there can be defined any 2-dimensional area to be provided with the solid layer. The definition of the geometry of the area can be made by a computer program controlling a printer head of an inkjet printer. Within the area there is then printed by means of an inkjet printer a regular 2-dimensional pattern of discrete droplets. Adjacent droplets are arranged at a predetermined distance.

Afterwards the droplets are dried and islands of a solid material are formed. Then the area containing the islands is covered by a liquid layer of the solution. The predetermined distance of the islands is selected such that a substrate is continuously wetted within the areas by the liquid. The islands act as "anchor points" enabling a uniform wetting. A distance between the adjacent droplets or the islands formed from the droplets, respectively, is predetermined such that a uniform wetting within the area is enabled. The predetermined distance depends on the kind of the solution and the material of the substrate. For each combination of a substrate and a solution there exists a minimum and a maximum distance for the droplets or the islands, respectively. If the maximum distance is exceeded the solution does not form a meniscus between adjacent islands. In this case a uniform wetting is not enabled. The predetermined distance shall be between the minimum and the maximum distance.

By the proposed method there can be easily produced a solid layer from a solution where the solution has poor wetting probabilities with respect to the surface of a substrate. By the proposed use of an inkjet printer it is easily possible to set a suitable predetermined distance for a given substrate and solution. When a predefined geometry of the area is filled with the proposed regular 2-dimensional pattern of droplets there can be produced easily a corresponding pattern of islands by drying. This pattern of islands can then be directly covered by a liquid layer. For that step it is not necessary to cover a pattern by a flat plate or the like and to infiltrate the solution within a gap formed between the substrate and the flat plate. - Further, by the proposed method it is possible to manufacture 2-dimensional patterns without the use of masks. Such patterns may be produced even in a $\mu$m-range. Finally, the proposed method allows a continued production of e. g. organic photovoltaic cells.

The area to be covered by a solid layer is determined by the geometry of the 2-dimensional pattern. Further areas outside the area are not wetted by the solution. By the proposed method it is possible to specifically cover just the area with the solid layer. This allows for enhanced production e. g. of organic solar cells by wet processing.

Advantageously the predetermined distance may be 0.01 to 0.20 mm, preferably 0.05 to 0.17 mm. E.g. the predetermined distance may be produced by an inkjet printer having a resolution in a range of 150 to 500 DPI. If an inkjet printer is operated at such low resolution the pattern of the droplets can be produced relatively fast.

According to a further embodiment the droplets are arranged in the pattern along parallel lines. The droplets may form in the pattern in the corners of a triangle, rectangle, parallelogram, trapeze, square or rhombus. A side length of said geometrical forms is preferably in accordance with the predetermined distance.

The proposed patterns facilitate the production of a uniform solid layer within the boundaries of the area. Such geometrical forms may be easily produced by droplets being arranged on parallel lines where the droplets of the adjacent lines are arranged with a predetermined offset.

According to a further embodiment of the invention the droplets are dried at a temperature in the range of 25 to 200 °C, preferably in a range of 50 to 170 °C. The droplets may be dried for a period up to 10 minutes, preferably 2 to 7 minutes. The drying conditions depend on the material of the substrate as well as on the kind of the solution. It was found that by using parameters within the proposed ranges islands can be produced which firmly adhere at the surface of the substrate. Further, islands produced in such a way do not dissolve again when covered by the solution.

The area may be covered with the liquid layer by means of an inkjet printer, dip coating, slot die coating, spray coating or blade coating. However, it is preferred to use for the coating process an inkjet printer. Thereby the liquid layer can be printed exclusively within the boundaries of the area. It is not necessary to remove an excess of liquid outside the boundaries of the area.

The substrate is advantageously made of an organic photovoltaic active layer material, preferably P3HT:PCBM.

The solid material forming the islands and the solid layer comprises advantageously PEDOT:PSS.

Embodiments of the invention are described with reference to the drawings.

Fig. 1       shows steps of the method,

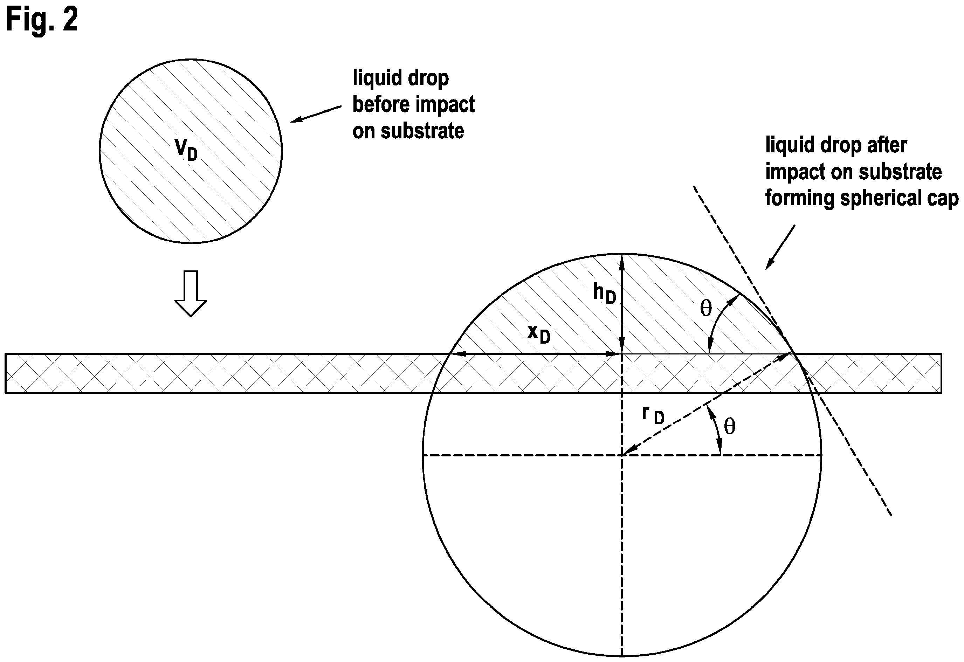

Fig. 2       shows a geometrical description of a droplet on the substrate,

Fig. 3a      shows with a printing pattern of PEDOT:PSS on a P3HT:PCBM surface at a resolution of 200 DPI,

Fig. 3b      shows with a printing pattern of PEDOT:PSS on a P3HT:PCBM surface at a resolution of 400 DPI,

Fig. 3c      shows with a printing pattern of PEDOT:PSS on a P3HT:PCBM surface at a resolution of 800 DPI,

Fig. 4a      shows a geometrical description of an array of islands covered with a homogeneous continuous wet layer before dewetting,

Fig. 4b      shows a geometrical description of an array of islands covered with a spherical cup of liquid as a result of dewetting,

Fig. 4c      shows a geometrical description of a spherical cup of liquid surrounding a single island as a result of dewetting,

Fig. 5       shows a microscopic image of a P3HT:PCBM surface with inkjet printed PEDOT:PSS islands having a distance larger than the predetermined maximum distance,

Fig. 6      shows microscopic images of PEDOT:PSS islands on a P3HT:PCBM surface, left: island dried at 65 °C for 5 min. right: island dried at 140 °C for 5 min,

Fig. 7      shows P3HT:PCBM surface being partly covered with PEDOT:PSS island,

Fig. 8      shows the current density voltage curve of an organic P3HT:PCBM solar cell where the PEDOT:PSS layer was applied in accordance with the invention, and

Fig. 9      shows box plot performance statistics of organic P3HT:PCBM solar cells where the PEDOT:PSS layer was applied in accordance with the invention.

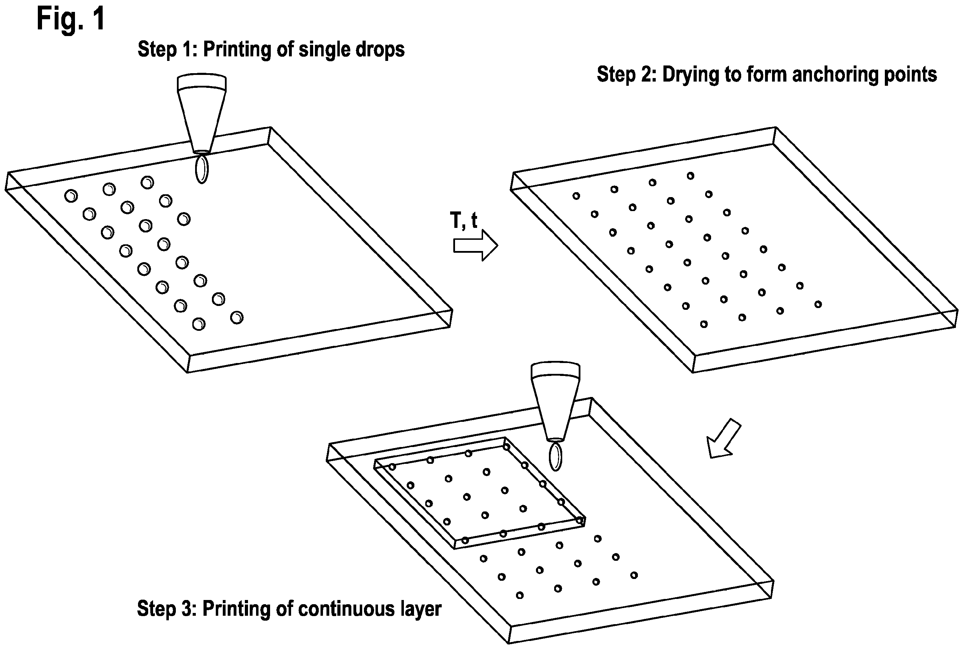

The method according to the invention is shown in Fig. 1:

1. In a first step the desired pattern is inkjet printed in a low resolution of typically 150 - 500 DPI. This creates an array of single droplets on the surface. As the resolution is low compared to conventional layer printing, this step is usually very fast.

2. Following, the ink is dried, resulting in shrinkage of the droplets and formation of small solid islands or "islands", respectively.

3. Finally, a continuous liquid layer is printed. As the liquid wets on the previously placed islands, shrinkage and layer rupturing due to dewetting can be prevented.

As a too low number of islands results in the rupturing of the subsequent layer while a too high number of islands results in the merging of the single droplets, a distinct processing window can be defined. In the following part, a simple way of estimating limits and an experimental confirmation thereof is provided.

Highest DPI:

To find the highest number of islands which can be applied on a substrate, the liquid droplets before drying have to be considered.

The following assumptions are made for facilitated calculation:

- The droplets ejected from the print head nozzle and of the freshly applied island on the substrate have equal volumes ($V_{\text{Spectra S class}}$ = 30 pi);
- Droplets on the substrate are shaped as spherical cap with the equilibrium contact angle $\theta$ (no consideration of gravity or splashing due to droplet velocity).

As the mentioned effects, which are not considered for the calculation, will lead to broadening of the droplets on the substrate, an additional constant scaling factor A is introduced and determined experimentally.

With a geometrical description of the spherical cap, equation 1 can be generated. In this equation $V_D$ refers to the droplet volume, h to the height of the spherical cap and $x_D$ to the radius of the spherical cap base circle (which is the minimum island distance before merging). Considering the geometric relation between height and radius of the spherical cap (equation 2), equation 3 can be created. With the island distance known, the maximum Resolution ($\text{Res}_{\text{max,calc}}$) can be calculated (equation 4).

$$V_D = V_{sphericalCap} = \frac{h_D \pi}{6}(3 x_D{}^2 + h^2) \tag{1}$$

$$h_D = x_D * \tan\left(\frac{\theta}{2}\right) \tag{2}$$

$$x_D = \sqrt[3]{\frac{6 * V_D}{\pi * \tan\left(\frac{\theta}{2}\right) * \left(3 + \tan^2\left(\frac{\theta}{2}\right)\right)}} \qquad (3)$$

$$Res_{max,calc}[DPI] = \frac{25.4\left[\frac{mm}{inch}\right]}{2 * x_D} \qquad (4)$$

$$Res_{max,cor}[DPI] = A * \frac{25.4\left[\frac{mm}{inch}\right]}{2 * x_D} \qquad (5)$$

Table 1: Maximum resolution of islands for different PEDOT:PSS inks L. Eisenhofer, Masterthesis: Process development for inkjet printing of PEDOT:PSS hole injection layers; Supervision P. Maisch, H.-J. Egelhaaf, M. Voigt, C.J. Brabec, 2015.

| Ink | $\theta$ P3HT:PCBM | $V_D$ | $Res_{max,calc.}$ | $Res_{exp}$ | A |
|---|---|---|---|---|---|
| | (°) | (pl) | (DPI) | (DPI) | |
| P Jet NV2 | 32.9 | 30 | 320 | 200 | 0.63 |
| FHC Solar | 38.2 | 30 | 339 | 200 | 0.59 |
| PVP AL 4083 | 110.28 | 30 | 598 | 400 | 0.67 |

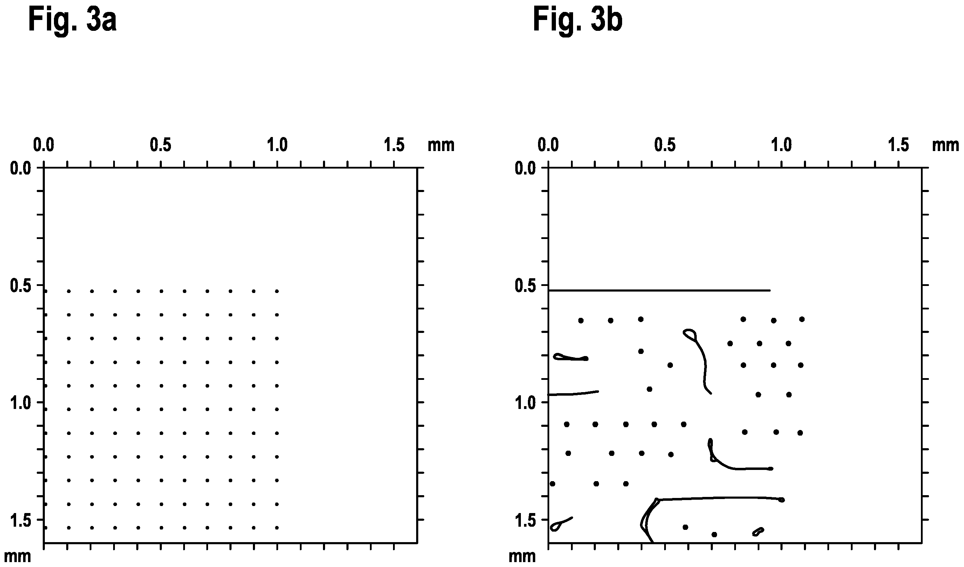

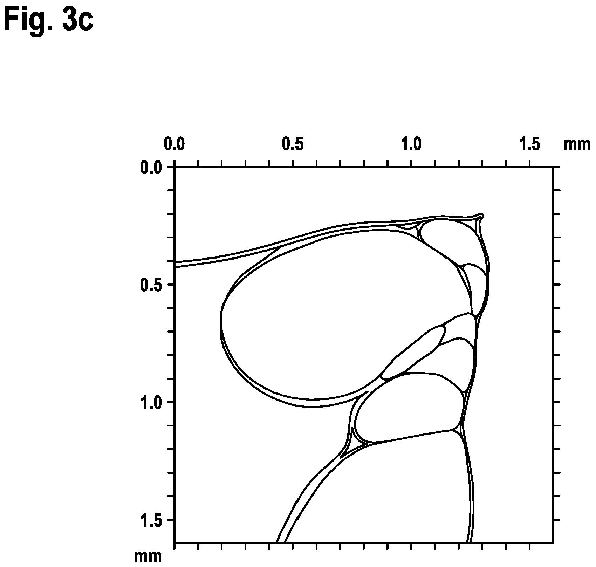

The corrected resolution ($Res_{max,cor}$) which accounts for all effects leading to liquid droplet broadening, for example due to the droplet velocity upon impact on the substrate, is given in equation 5. Figs. 3a to 3c show islands of DEPOT:PSS ink printed with P Jet NV2 on P3HT:PCBM layers with different DPI numbers: Fig. 3a: 200 DPI - regular pattern of islands, Fig. 3b: 400 DPI - islands start to merge, Fig. 3c: 800 DPI - complete layer of ink which dewetts on the surface. As can be seen in Fig. 3a to 3c, the experimentally found DPI numbers match well with the calculated values using the experimentally found scaling factor A of ~0.6.

Lowest DPI:

For calculating the lowest island resolution before rupturing of the secondly printed layer occurs, the free energies of the sample before ($F_b$) and after ($F_a$) dewetting have to be compared. Layer rupturing will occur, if the difference of free energies ($\Delta F$) is smaller than 0 (equation 6).

$$\Delta F = F_a - F_b < 0 \qquad (6)$$

To describe the free energies of the system, the three interface areas, solid-vapor (Asv), solid-liquid ($A_{SL}$) and liquid-vapor ($A_{LV}$) as well as the corresponding surface tensions $\sigma_{SV}$, $\sigma_{SL}$ and $\sigma_{LV}$ have to be considered. This results in equation 7.

$$\Delta F = A_{SVa} * \sigma_{SV} + A_{SLa} * \sigma_{SL} + A_{LVa} * \sigma_{LV} - A_{SVb} * \sigma_{SV} - A_{SLb} * \sigma_{SL} - A_{LVb} * \sigma_{LV} \qquad (7)$$

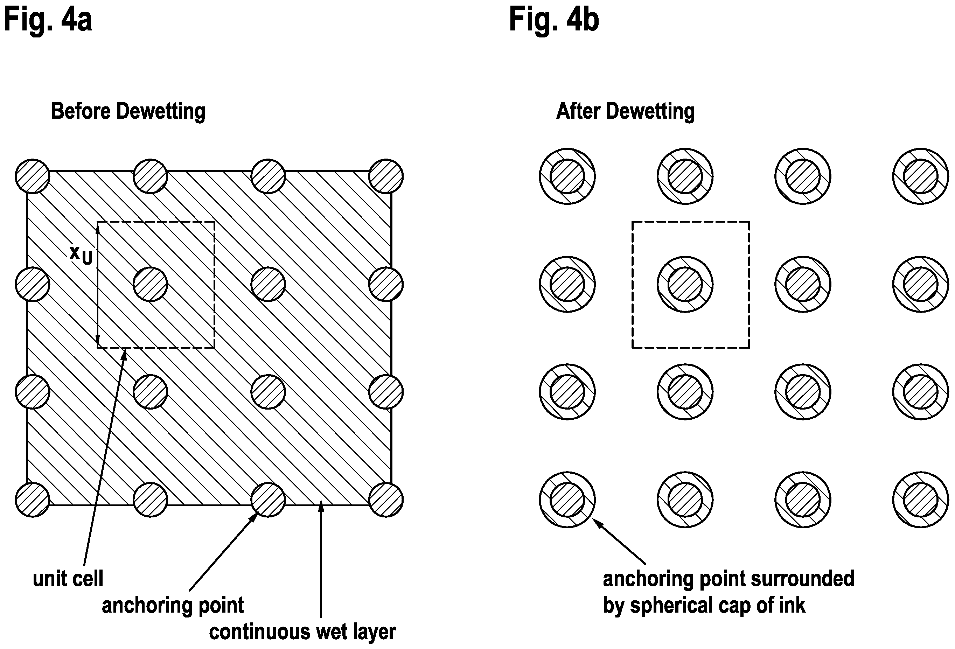

The interface areas before and after dewetting can be described with geometric equations (equations 8-13). An illustration of the dewetting process can be seen in Fig. 4a to 4c. To simplify the mathematics of the symmetrical island layout, only one unit cell with the length xu as shown in Fig. 4a is considered.

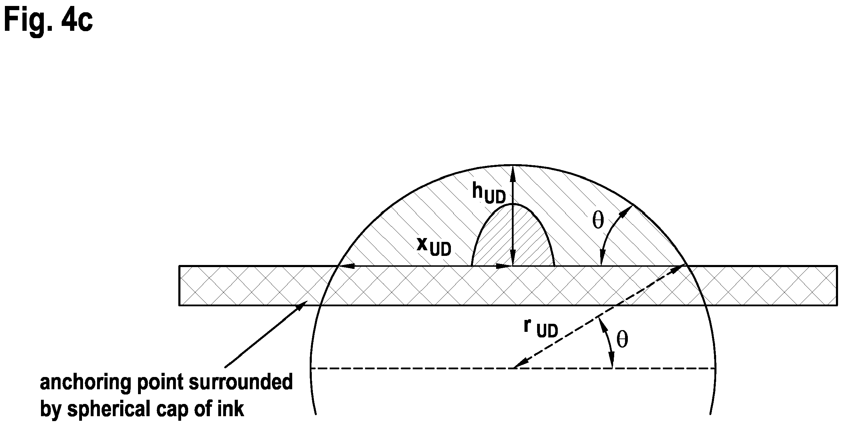

Fig. 4 shows schematically the dewetting of a liquid film. Fig. 4a shows a top view on islands and a closed liquid layer directly after printing; Fig. 4b shows a top view on islands and dewetted ink surrounding them as a spherical cap; Fig. 4c shows a cross cut through the spherical cap. After dewetting, a spherical cap of ink surrounding a single island is assumed, Fig. 4b, Fig. 4c. This cap can be described with the base circle radius $x_{UD}$, the height $h_{UD}$ and the equilibrium contact angle $\theta$. Under the assumption, that the island is fully covered by PEDOT:PSS ink and its volume is negligible (solid contents of ink are usually very low ~1-5 %), the same geometry as in equation 2, equation 3 applies to the system. These equations together with the Young's law (eq 14) can be used to substitute $h_{UD}$, $x_{UD}$, $\sigma_{SV}$, $\sigma_{SL}$ and $\sigma_{LV}$.

$$A_{SVa} = x_U{}^2 - \pi * x_{UD}{}^2 \qquad\qquad A_{SVb} = 0$$
$$A_{SLa} = \pi * x_{UD}{}^2 \qquad\qquad A_{SLb} = x_U{}^2 \qquad\qquad \textbf{(8-13)}$$
$$A_{LVa} = \pi * (x_{UD}{}^2 + h_{UD}{}^2) \qquad\qquad A_{LVb} = x_U{}^2$$

$$h_{UD} = x_{UD} * \tan\left(\frac{\theta}{2}\right); \quad x_{UD} = \sqrt[3]{\frac{6*V_{UD}}{\pi*\tan\left(\frac{\theta}{2}\right)*\left(3+\tan^2\left(\frac{\theta}{2}\right)\right)}} \text{ (analogous to eq. 2, eq. 3)}$$

$$\cos(\theta) = \frac{\sigma_{SV} - \sigma_{SL}}{\sigma_{LV}} \qquad\qquad \textbf{(14)}$$

$$x_U < \sqrt[3]{\frac{6*V_{UD}}{\pi * \tan\left(\frac{\theta}{2}\right) * \left(3 + \tan^2\left(\frac{\theta}{2}\right)\right)}} * \sqrt{\pi * \left(1 + \frac{1}{1 - \sin(\theta)}\right)} \qquad\qquad \textbf{(15)}$$

$$\boldsymbol{Res_{min}}[DPI] < \frac{25.4\left[\frac{mm}{inch}\right]}{x_U} \qquad\qquad \textbf{(16)}$$

Consequently, ΔF can be described as function of the volume of ink on the unit cell $V_{UD}$, $x_U$ and $\theta$. Mathematical reshaping of equation 6 leads to an expression for the unit cell length $x_U$ (equation 15), which corresponds to the biggest distance between islands before the liquid layer covering them starts to rupture. Equation 16 gives the corresponding minimum island resolution $Res_{min}$.

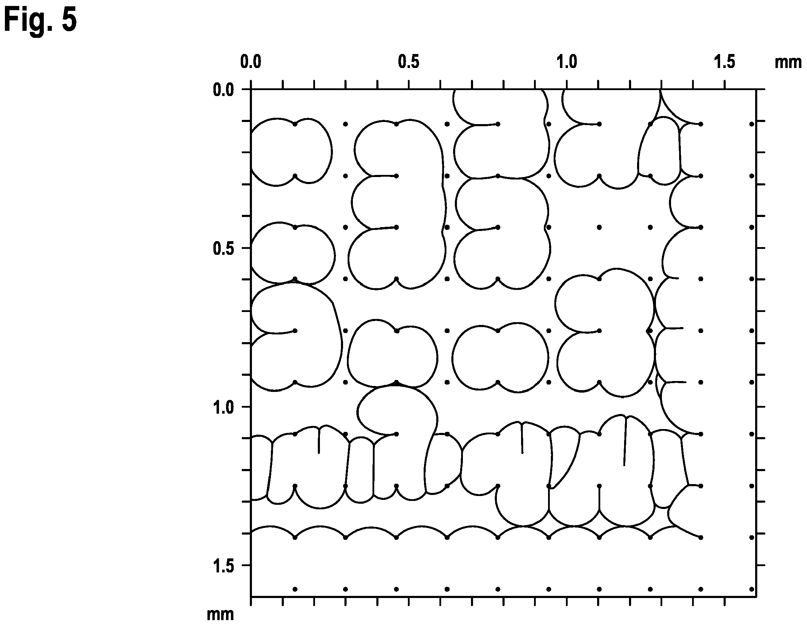

Fig. 5 shows a liquid layer of PEDOT:PSS on a surface of P3HT:PCBM with an island resolution Res < $Res_{min}$. Islands with too low DPI cannot prevent dewetting, as rupturing of the wet layer between the islands occurs.

The influence of island drying:

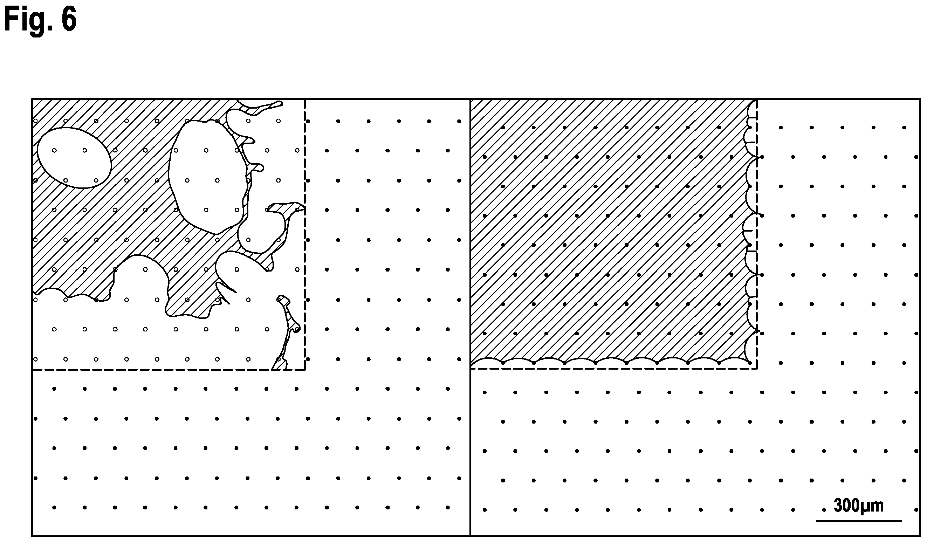

Another important parameter is the curing temperature of the islands. It was found, that insufficiently cured islands cannot stop dewetting of the subsequently printed continuous liquid layer. Fig. 6 shows microscopic images of P Jet NV2 printed islands on a P3HT:PCBM surface. The left picture shows islands being cured at 65 °C for five minutes, the right picture shows islands being cured at 140 °C for five minutes. Afterwards, a continuous liquid layer was P Jet NV 2 printed on the top of the island within the area marked by the doted lines. The mechanical forces introduced by the contracting liquid just peel the islands off the semiconductor surface (Fig. 6).

This is not surprising, as the relatively weak adhesion between P3HT:PCBM and PEDOT:PSS is well known from literature. A detailed description of PEDOT:PSS adhesion energy on P3HT:PCBM surfaces goes beyond the scope of this document and can be found e. g. S.R. Dupont, E. Voroshazi, D. Nordlund, K. Vandewal, R.H. Dauskardt, Controlling Interdiffusion , Interfacial Composition , and Adhesion in Polymer Solar Cells, Adv. Mater. Interfaces. (2014) 1-8. doi:10.1002/admi.201400135. As described in literature, adhesive failure occurs between P3HT:PCBM and an intermixed layer of P3HT:PCBM and PEDOT:PSS. With increasing annealing temperature this intermixed region expands and strengthens. For the island experiment with P Jet NV2 at 5 min curing time, a minimum curing temperature of 140 °C was determined.

Applicability of islands:

With the theory and optimization process of the island strategy already described, a proof of the applicability and comparison to established methods is to be done in the following section.

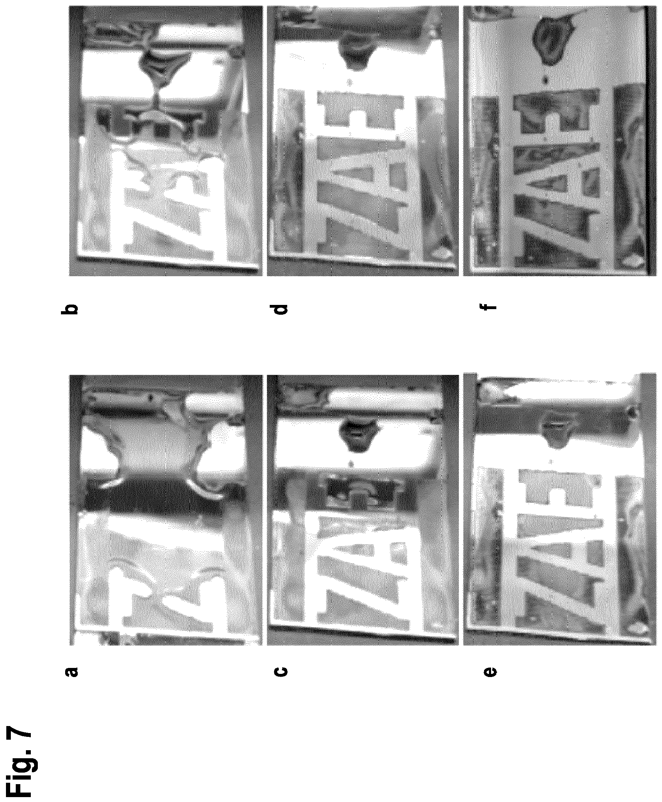

One advantage of the method according to the invention compared to prior art methods is the locally defined change of surface properties. This enables easy and fast structuring of layers. As the ink will only wet on the island modified part of the surface, the layer coating can even be done with a one dimensional process like doctor blading or slot die coating. The use of islands to locally modify the surface properties can be seen in Fig. 7. In Fig. 7 there were provided locally defined islands on a surface of P3HT:PCBM. Consequently, a liquid layer of PEDOT:PSS was applied on the surface. As can be seen from Fig. 7 the liquid layer only wets on the modified surface.

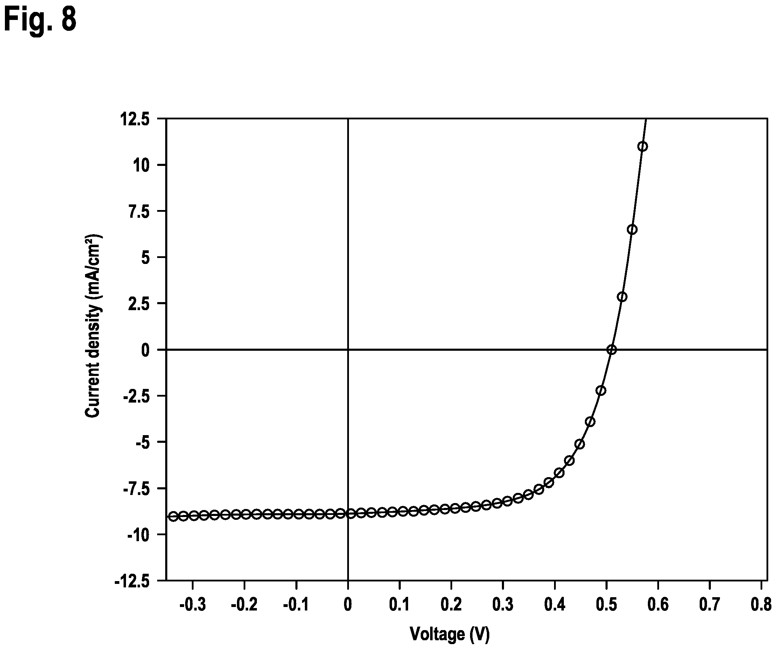

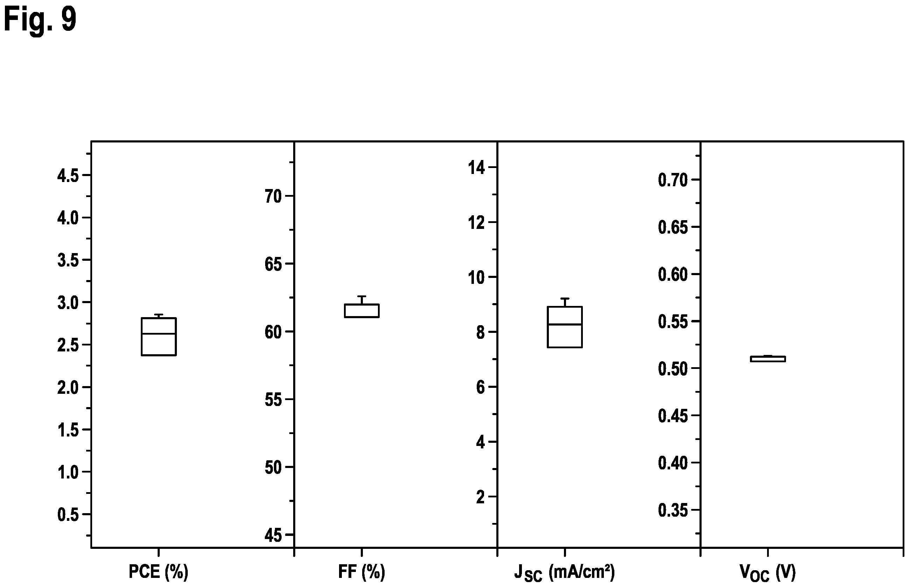

This structuring possibility enables the use of islands for a variety of applications like OLED or OPV. Fig. 8 shows the current density vs. the voltage for a solar cell using islands. The islands were printed in an inverted structure organic solar cell to overcome dewetting of hydrophilic PEDOT:PSS on the hydrophobic substrate material P3HT:PCBM. Fig. 9 shows in a boxplot the statistics of the performance of the aforementioned manufactured organic solar cells.

**Claims**

1. A method of applying upon a substrate a solid layer from a liquid which does not wet the substrate, the method comprising the following steps:

   Defining on the surface of the substrate an area to be provided with the solid layer,
   Printing by means of an inkjet printer a regular 2-dimensional pattern of discrete droplets within the area, wherein adjacent droplets are arranged at a predetermined distance,
   Drying the droplets thereby forming islands of a solid material,
   Covering the area containing the islands by a liquid layer of the liquid, and
   Drying the liquid layer thereby forming the solid layer.

2. The method of claim 1, wherein the predetermined distance is 0.01 to 0.20 mm, preferably 0.05 to 0.17 mm.

3. The method according to one of the previous claims, wherein the droplets are arranged in the pattern along parallel lines.

4. The method according to one of the previous claims, wherein the droplets form in the pattern the corners of a triangle, rectangle, parallelogram, trapeze, square or rhombus.

5. The method according to one of the previous claims, wherein the droplets are dried at a temperature in the range of 25 to 200 °C, preferably in a range of 50 to 170 °C.

6. The method according to one of the previous claims, wherein the droplets are dried for a period up to 10 minutes, preferably 2 to 7 minutes.

7. The method according to one of the previous claims, wherein the area is covered with the liquid layer by means of an inkjet printer, dip coating, slot die coating, spray coating, or blade coating.

8. The method according to one of the previous claims, wherein the substrate is made of an organic photovoltaic active layer material, preferably P3HT:PCBM.

9. The method according to one of the previous claims, wherein the solid material forming the islands and the solid layer comprises PEDOT:PSS.

## Fig. 1

**Step 1: Printing of single drops**

**Step 2: Drying to form anchoring points**

T, t

**Step 3: Printing of continuous layer**

EP 3 396 730 A1

# Fig. 2

liquid drop
before impact
on substrate

$V_D$

liquid drop after
impact on substrate
forming spherical cap

$h_D$

$x_D$

$\theta$

$r_D$

$\theta$

EP 3 396 730 A1

Fig. 3b

Fig. 3a

Fig. 3c

# Fig. 4a

**Before Dewetting**

$x_U$

unit cell

anchoring point

continuous wet layer

# Fig. 4b

**After Dewetting**

anchoring point surrounded
by spherical cap of ink

EP 3 396 730 A1

Fig. 4c

anchoring point surrounded
by spherical cap of ink

Fig. 5

**Fig. 6**

300µm

# Fig. 7

**Fig. 8**

**Fig. 9**

Europäisches
Patentamt

European
Patent Office

Office européen
des brevets

**EUROPEAN SEARCH REPORT**

Application Number

EP 17 19 6647

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/280847 A1 (LEWIS JASON [US] ET AL) 24 October 2013 (2013-10-24) * page 5, paragraph 56 - paragraph 60; example 1 * | 1-9 | INV. H01L51/48 |
| A | WO 2012/101207 A2 (UNIV DENMARK TECH DTU [DK]; KREBS FREDERIK CHRISTIAN [DK]) 2 August 2012 (2012-08-02) * the whole document * | 1-9 | |
| A | US 6 283 589 B1 (GELBART DANIEL [CA]) 4 September 2001 (2001-09-04) * the whole document * | 1-9 | |

TECHNICAL FIELDS
SEARCHED      (IPC)

H01L

The present search report has been drawn up for all claims

| Place of search | Date of completion of the search | Examiner |
|---|---|---|
| The Hague | 17 May 2018 | Parashkov, Radoslav |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 19 6647

This annex lists the patent family members relating to the patent documents cited in the above-mentioned European search report.
The members are as contained in the European Patent Office EDP file on
The European Patent Office is in no way liable for these particulars which are merely given for the purpose of information.

17-05-2018

| Patent document cited in search report | Publication date | Patent family member(s) | Publication date |
|---|---|---|---|
| US 2013280847 A1 | 24-10-2013 | NONE | |
| WO 2012101207 A2 | 02-08-2012 | NONE | |
| US 6283589 B1 | 04-09-2001 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CHEN et al.** Fabrication of Nanoscale Circuits on Inkjet-Printing Patterned Substrates. *Adv. Mater.,* 2015, vol. 27, 3928-3933
- **A. COLSMANN et al.** Inverted semi-transparent organic solar cells with spray coated, surfactant fee polymer top-electrodes. *Sol. Energy Mater. Sol. Cells.,* 2012, vol. 98, 118-123

- **S.R. DUPONT ; E. VOROSHAZI ; D. NORDLUND ; K. VANDEWAL ; R.H. DAUSKARDT.** Controlling Interdiffusion , Interfacial Composition , and Adhesion in Polymer Solar Cells. *Adv. Mater. Interfaces.,* 2014, 1-8